# EUROPÄISCHE PATENTSCHRIFT

(11) **EP 3 349 021 B1**
(45) Veröffentlichungstag und Bekanntmachung des Hinweises auf die Patenterteilung: **12.12.2018**
(21) Anmeldenummer: 18159668.5
(22) Anmeldetag: 25.01.2010
(51) Int. Cl.: G01R 13/02, G01R 1/067

(54) **MESSGERÄT UND MESSVERFAHREN ZUR MESSUNG DIFFERENTIELLER SIGNALE**
MEASURING DEVICE AND MEASUREMENT METHOD FOR MEASURING DIFFERENTIAL SIGNALS
APPAREIL DE MESURE ET PROCÉDÉ DE MESURE DESTINÉS À MESURER DES SIGNAUX DIFFÉRENTIELS

(30) Priorität: 27.04.2009 DE 102009019039
(43) Veröffentlichungstag der Anmeldung: 18.07.2018
(62) Teilanmeldung aus: 10704898.5
(73) Patentinhaber: Rohde & Schwarz GmbH & Co. KG, 81671 München (DE)
(72) Erfinder: Kuhwald, Thomas, 85570 Markt Schwaben (DE); Huber, Johann, 85570 Markt Schwaben (DE); Reinhold, Michael, 81929 München (DE); Herbordt, Wolfgang, 85521 München. (DE); Freidhof, Markus, 85614 Kirchseeon (DE)
(74) Vertreter: Körfer, Thomas

(56) Entgegenhaltungen:
- WO-A1-2007/071608
- DE-A1-102005 035 473
- US-A- 4 812 746

## Beschreibung

Die Erfindung betrifft ein Messgerät und ein Messverfahren zur Messung differentieller Signale, insbesondere zur Messung eines differentiellen Signals ohne Anwendung eines differentiellen Tastkopfs.

Mit herkömmlichen Oszilloskopen können differenzielle Signale nicht ohne Einschränkungen gemessen werden. Bei Einsatz üblicher Tastköpfe mit jeweils einer Messspitze an zwei unterschiedlichen Kanälen des Oszilloskops kann eine Triggerung lediglich für eines der beiden empfangenen Signale durchgeführt werden. Bei nicht idealen differentiellen Signalen, wie z.B. einem stark verrauschten Teilsignal, ist eine Triggerung nicht immer erfolgreich. Insbesondere jedoch bei differentiellen Signalen, welche mit einem starken, weitgehend identischen Rauschsignal beaufschlagt sind, ist eine Triggerung auf nur ein Teilsignal oftmals nicht möglich.

Zur Verbesserung der Messung differentieller Signale ist der Einsatz differentieller Tastköpfe bekannt. Dabei verfügt ein Tastkopf über zwei Messspitzen für die beiden Teilsignale des differentiellen Signals. Der differentielle Tastkopf ist an einen einzelnen Kanal eines Oszilloskops angeschlossen. Das gesamte differentielle Signal wird über diesen einen Kanal des Oszilloskops gemessen. Die Triggerung ist hier unproblematisch.

So zeigt die US 6,973,407 B1 eine Messanwendung eines differentiellen Tastkopfs. Differentielle Tastköpfe sind jedoch sehr teuer in der Anschaffung. Aus diesem Grund sind sie nicht immer verfügbar bzw. die Anschaffung nicht immer lohnenswert.

Der Erfindung liegt die Aufgabe zugrunde, ein Messgerät und ein Messverfahren zu schaffen, welche eine zuverlässige Messung differentieller Signale ohne den Einsatz eines aufwendigen differentiellen Tastkopfs ermöglichen.

Die Aufgabe wird erfindungsgemäß für das Messgerät durch die Merkmale des unabhängigen Anspruchs 1 und für das Messverfahren durch die Merkmale des unabhängigen Anspruchs 7 gelöst. Vorteilhafte Weiterbildungen sind Gegenstand der hierauf rückbezogenen Unteransprüche.

Gemäß einem ersten Aspekt dient ein Messgerät zur Messung von differentiellen Signalen mit einem Echtzeitabschnitt. Dabei beinhaltet der Echtzeitabschnitt zwei Einrichtungen mit jeweils einem Signalanschluss und einem Masseanschluss, zwei Analog-Digital-Wandler, einen Signaladdierer und/oder Signalsubtrahierer und eine Triggereinrichtung. Die Einrichtungen mit jeweils einem Signalanschluss und einem Masseanschluss nehmen jeweils ein Teilsignal eines differentiellen Signals auf. Die Analog-Digital-Wandler wandeln jeweils ein Teilsignal in ein digitales Teilsignal, wobei der Signaladdierer bzw. Signalsubtrahierer die digitalen Teilsignale zu einem digitalen differentiellen Signal addiert bzw. subtrahiert. Die Triggereinrichtung führt eine Triggerung des digitalen differentiellen Signals anhand des digitalen differentiellen Signals durch.

Gemäß einem zweiten Aspekt dient ein Messverfahren zur Messung von differentiellen Signalen, wobei von zwei Einrichtungen mit jeweils einem Signalanschluss und einem Masseanschluss jeweils ein Teilsignal eines differentiellen Signals aufgenommen wird. Zwei Analog-Digital-Wandler wandeln jeweils ein Teilsignal in ein digitales Teilsignal, wobei die digitalen Teilsignale zu einem digitalen differentiellen Signal addiert oder subtrahiert werden. Die Triggerung des digitalen differentiellen Signals wird anhand des digitalen differentiellen Signals durchgeführt, wobei das differentielle Signal weiterverarbeitet und/oder gespeichert wird.

Ein erfindungsgemäßes Messgerät zur Messung von differentiellen Signalen verfügt vorzugsweise über einen Echtzeitabschnitt, welcher zwei Tastköpfe, einen Signaladdierer bzw. Signalsubtrahierer und eine Triggereinrichtung beinhaltet. Die Tastköpfe nehmen jeweils ein Teilsignal eines differentiellen Signals auf. Der Signaladdierer bzw. Signalsubtrahierer addiert bzw. subtrahiert die Teilsignale zu einem differentiellen Signal. Die Triggereinrichtung führt eine Triggerung anhand des differentiellen Signals durch. So ist eine sichere Triggerung gewährleistet.

Das Messgerät beinhaltet bevorzugt eine Verarbeitungseinrichtung. Die Verarbeitungseinrichtung verarbeitet und/oder speichert vorteilhafterweise das differentielle Signal und/oder zumindest ein Teilsignal des differentiellen Signals. So ist eine genaue Analyse des differentiellen Signals möglich.

Der Echtzeitabschnitt beinhaltet bevorzugt zwei Analog-Digital-Wandler. Die Analog-Digital-Wandler digitalisieren bevorzugt die aufgenommenen Teilsignale. Der Signaladdierer bzw. Signalsubtrahierer addiert bzw. subtrahiert bevorzugt die digitalen Teilsignale digital. So ist eine genaue Addition gewährleistet.

Vorteilhafterweise sind der Signaladdierer bzw. Signalsubtrahierer und/oder die Triggereinrichtung mittels eines FPGA (field programmable gate array) oder eines ASIC (application specific gated array) realisiert. So kann das erfindungsgemäße Messgerät mit geringem Aufwand entwickelt und hergestellt werden.

Die Tastköpfe beinhalten bevorzugt jeweils genau einen Signalanschluss und einen Masseanschluss. So können günstige, einfach verfügbare Tastköpfe eingesetzt werden.

Das Messgerät verfügt bevorzugt über eine Anzeigeeinrichtung. Die Anzeigeeinrichtung zeigt vorteilhafterweise Ergebnisse durchgeführter Messungen an. So können die Ergebnisse der Messungen ohne weitere Geräte, wie z.B. einen externen Bildschirm dargestellt werden.

Der Echtzeitabschnitt verarbeitet bevorzugt eingehende Signale mit einer Abtastrate der Analog-Digital-Wandler ohne sie zu speichern. So wird eine zuverlässige Triggerung erreicht.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: ein beispielhaftes Messgerät;
- Fig. 2: ein Ausführungsbeispiel des erfindungsgemäßen Messgeräts, und
- Fig. 3: ein Ausführungsbeispiel des erfindungsgemäßen Messverfahrens.

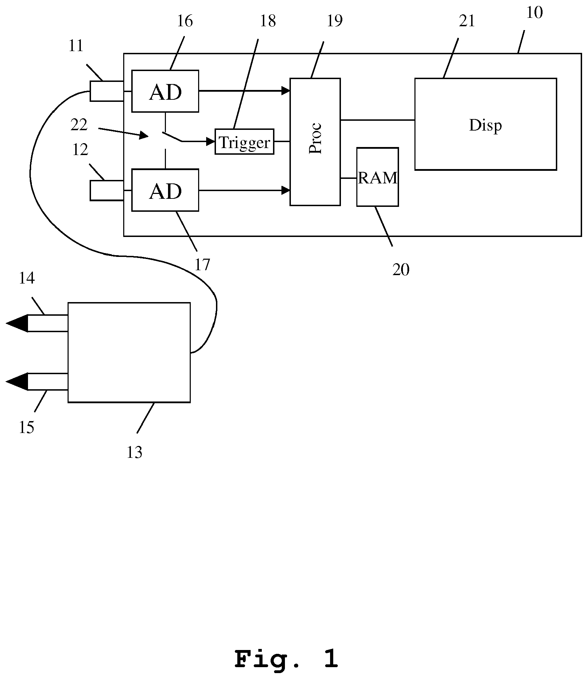

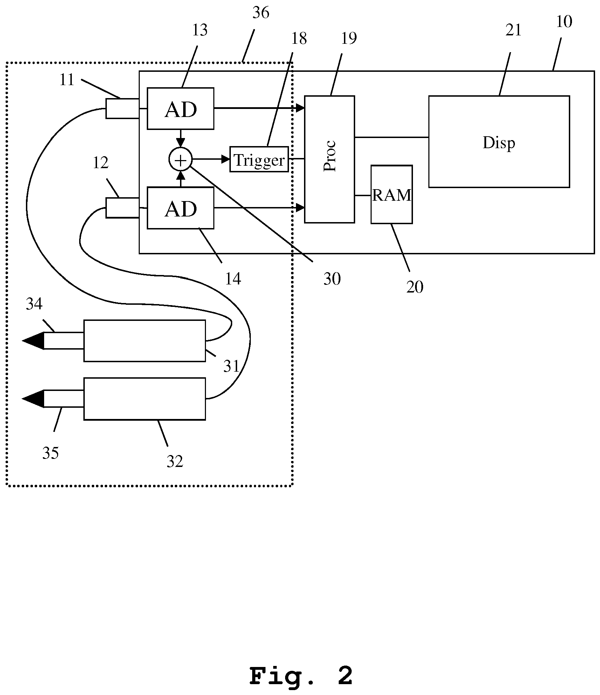

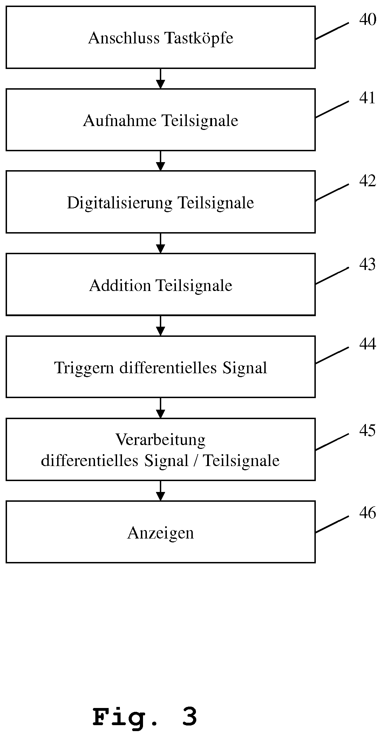

Zunächst wird anhand der Fig. 1 die dem erfindungsgemäßen Messgerät und dem erfindungsgemäßen Messverfahren zu Grunde liegende Problematik anhand eines beispielhaften Messgeräts erläutert. Anhand von Fig. 2 wird der Aufbau und die Funktionsweise eines Ausführungsbeispiels des erfindungsgemäßen Messgeräts veranschaulicht. Anhand der Fig. 3 wird die Funktionsweise eines Ausführungsbeispiels des erfindungsgemäßen Messverfahrens gezeigt. Identische Elemente wurden in ähnlichen Abbildungen zum Teil nicht wiederholt und beschrieben.

Fig. 1 zeigt ein beispielhaftes Messgerät. Ein differentieller Tastkopf 13 mit den beiden Messspitzen 14, 15 ist über einen ersten Anschluss 11 mit einem Gehäuse 10 verbunden. Das Messgerät verfügt über einen zweiten Anschluss 12. Weiterhin verfügt das Messgerät über zwei Analog-Digital-Wandler 16, 17. Der erste Analog-Digital-Wandler 16 ist dem ersten Anschluss 11 zugeordnet und mit diesem verbunden. Der zweite Analog-Digital-Wandler 17 ist mit dem zweiten Anschluss 12 verbunden. Eine Trigger-Einrichtung 18 ist über einen Schalter wahlweise mit dem ersten Analog-Digital-Wandler 16 oder mit dem zweiten Analog-Digital-Wandler 17 verbunden. Die Analog-Digital-Wandler 16, 17 und die Trigger-Einrichtung 18 sind mit einer Verarbeitungseinrichtung 19 verbunden. Die Verarbeitungseinrichtung 19 ist weiterhin mit einem Speicher 20 und einer Anzeigeeinrichtung 21 verbunden.

Die Messspitzen 14, 15 des differentiellen Tastkopfs 13 werden mit einem differentiellen Signal beaufschlagt. Der differentielle Tastkopf 13 überträgt das analoge differentielle Signal an den Anschluss 11. Von dort gelangt es zu dem ersten Analog-Digital-Wandler 16. Dieser digitalisiert das Signal und leitet es bei der gezeigten Schalterstellung an die Trigger-Einrichtung 18 und an die Verarbeitungseinrichtung 19 weiter. Die Trigger-Einrichtung 18 führt eine Triggerung des digitalisierten Signals durch. Die Trigger-Einrichtung 18 wird dabei von der Verarbeitungseinrichtung 19 gesteuert. Die Verarbeitungseinrichtung 19 verarbeitet das getriggerte digitalisierte differentielle Signal weiter und speichert es in dem Speicher 20. Darüber hinaus stellt sie das Signal auf der Anzeigeeinrichtung 21 dar.

Nachteilhaft an diesem beispielhaften Messgerät ist, dass ein differentieller Tastkopf aufwendig in der Herstellung ist. Weiterhin nachteilig ist, dass die beiden Teilsignale, aus welchen das differentielle Signal zusammengesetzt ist, nicht getrennt voneinander verarbeitet werden können. Treten z.B. Störungen in einem der beiden Teilsignale auf, so können diese nicht lokalisiert werden. Liegt z.B. ein starkes Rauschen in einem der beiden Teilsignale vor, so ist eine zuverlässige Triggerung durch die Trigger-Einrichtung nicht möglich und eine weitere Verarbeitung des gesamten differentiellen Signals wird unmöglich.

Fig. 2 zeigt ein Ausführungsbeispiel des erfindungsgemäßen Messgeräts. Zwei herkömmliche Tastköpfe 31, 32 verfügen über jeweils eine Messspitze 34, 35. Der erste Tastkopf 31 ist mit einem ersten Anschluss 11 verbunden. Der zweite Tastkopf 32 ist mit einem zweiten Anschluss 12 verbunden.

Die Anschlüsse 11, 12 sind an einem Gehäuse 10 angeordnet. Der erste Anschluss 11 ist mit einem Analog-Digital-Wandler 13 verbunden. Der zweite Anschluss 12 ist mit einem zweiten Analog-Digital-Wandler 14 verbunden. Die beiden Analog-Digital-Wandler 13, 14 sind mit einem Signaladdierer 30 verbunden. Weiterhin sind sie mit einer Verarbeitungseinrichtung 19 verbunden. Der Signaladdierer 30 ist weiterhin mit einer Trigger-Einrichtung 18 verbunden. Die Trigger-Einrichtung 18 ist ebenfalls mit der Verarbeitungseinrichtung 19 verbunden. Die Analog-Digital-Wandler 13, 14 der Signaladdierer 30, die Trigger-Einrichtung 18 und die Tastköpfe 31, 32 bilden zusammen einen Echtzeit-Abschnitt 36 des Messgeräts. D.h. diese Komponenten arbeiten ohne Zwischenspeicherung und verarbeiten die eingehenden Signale mit der Geschwindigkeit des Signaleingangs. Die Verarbeitungseinrichtung 19 ist darüber hinaus mit einem Speicher 20 und einer Anzeigeeinrichtung 21 verbunden.

Ein differentielles Signal wird von den beiden Tastköpfen 21, 32 aufgenommen. Dabei wird ein erstes Teilsignal des differentiellen Signals mittels der Messspitze 34 von dem ersten Tastkopf 31 aufgenommen. Ein zweites Teilsignal des differentiellen Signals wird mittels der Messspitze 35 von dem zweiten Tastkopf 32 aufgenommen. Die Teilsignale des differentiellen Signals werden über die Anschlüsse 11, 12 den Analog-Digital-Wandlern 13, 14 zugeführt. Die Analog-Digital-Wandler 13. 14 wandeln die analogen Teilsignale des differentiellen Signals in digitale Teilsignale des differentiellen Signals um. Die digitalen Teilsignale werden dem Signaladdierer 30 zugeführt. Der Signaladdierer 30 addiert die Signale zu einem gemeinsamen differentiellen Signal und leitet es an die Trigger-Einrichtung 18 weiter. Die Trigger-Einrichtung 18 führt eine Triggerung des gemeinsamen differentiellen Signals durch. Die Triggerung wird dabei von der Verarbeitungseinrichtung 19 gesteuert. Die Analog-Digital-Wandler 13, 14 führen die digitalen Teilsignale des differentiellen Signals weiterhin der Verarbeitungseinrichtung 19 zu. Die Verarbeitungseinrichtung 19 verarbeitet die Teilsignale des differentiellen Signals weiter. Optional bildet die Verarbeitungseinrichtung 19 aus den Teilsignalen des differentiellen Signals durch Addition ein differentielles Signal. Die Verarbeitungseinrichtung 19 speichert die Teilsignale, bzw. das differentielle Signal in dem Speicher 20 und stellt Ergebnisse der Messungen auf der Anzeigeeinrichtung 21 dar.

Optional ist der Signaladdierer 30, die Trigger-Einrichtung 18 und die Verarbeitungseinrichtung 19 auf einem FPGA (field programmable gate array) oder einem ASIC (application specific gated array) ausgebildet.

Im Gegensatz zu dem in Fig. 1 dargestellten beispielhaften Messgerät ist bei dem erfindungsgemäßen Messgerät eine zuverlässige Verarbeitung und Messung des differentiellen Signals auch bei gestörten Teilsignalen des differentiellen Signals möglich. Weiterhin wird ein aufwändiger und häufig nicht verfügbarer differentieller Tastkopf nicht benötigt.

Fig. 3 zeigt ein erstes Ausführungsbeispiel des erfindungsgemäßen Messverfahrens. In einem ersten Schritt 40 werden zwei Tastköpfe jeweils mit einem Teilsignal eines differentiellen Signals beaufschlagt. Dies erfolgt üblicherweise durch Anschluss der Tastköpfe an ein Messobjekt. In einem zweiten Schritt 41 werden mittels der beiden Tastköpfe die beiden Teilsignale des differentiellen Signals aufgenommen. In einem dritten Schritt 43 werden die aufgenommenen Teilsignale des differentiellen Signals digitalisiert. Die Digitalisierung erfolgt dabei mit einer bestimmten Abtastrate. In einem vierten Schritt 43 werden die digitalisierten Teilsignale addiert. Die Addition erfolgt dabei in Echtzeit. D.h. für jeden Abtastwert der digitalisierten Teilsignale des differentiellen Signals wird ein addierter Abtastwert erzeugt. Die Addition erfolgt dabei derart, dass das resultierende Signal ein digitales differentielles Signal ist. Nötigenfalls wird eines der Teilsignale des differentiellen Signals invertiert oder es wird anstatt eines Signaladdierers ein Signalsubtrahierer eingesetzt, um eines der beiden Teilsignale von anderen Teilsignalen zu subtrahieren.

In einem fünften Schritt 44 wird eine Triggerung des so entstandenen digitalen differentiellen Signals durchgeführt. In einem sechsten Schritt 45 werden die digitalisierten Teilsignale des differentiellen Signals und das durch Addition entstandene differentielle Signal weiterverarbeitet. In einem siebten Schritt 46 werden Ergebnisse der Messung, d.h. Ergebnisse der Weiterverarbeitung aus dem sechsten Schritt, angezeigt.

Die Erfindung ist nicht auf das dargestellte Ausführungsbeispiel beschränkt. Wie bereits erwähnt, können unterschiedliche Messgeräte eingesetzt werden. Auch eine Erweiterung auf mehr als zwei Kanälen, d.h. auf mehreren differentiellen Signale ist denkbar. Alle vorstehend beschriebenen Merkmale oder in den Figuren gezeigten Merkmale sind im Rahmen der Erfindung beliebig vorteilhaft miteinander kombinierbar.

## Patentansprüche

1. Messgerät zur Messung von differentiellen Signalen mit einem Echtzeitabschnitt (36),
wobei der Echtzeitabschnitt (36) zwei Einrichtungen mit jeweils einem Signalanschluss und einem Masseanschluss (31, 32), zwei Analog-Digital-Wandler (13,14), einen Signaladdierer und/oder Signalsubtrahierer (30) und eine Triggereinrichtung (18) beinhaltet,
wobei die Einrichtungen mit jeweils einem Signalanschluss und einem Masseanschluss (31, 32) jeweils ein Teilsignal eines differentiellen Signals aufnehmen,
wobei die Analog-Digital-Wandler (13,14) jeweils ein Teilsignal in ein digitales Teilsignal wandeln,
wobei der Signaladdierer bzw. Signalsubtrahierer (30) die digitalen Teilsignale zu einem digitalen differentiellen Signal addiert bzw. subtrahiert,
**dadurch gekennzeichnet,**
**dass** die Triggereinrichtung (18) eine Triggerung des digitalen differentiellen Signals anhand des digitalen differentiellen Signals durchführt.

2. Messgerät nach Anspruch 1,
**dadurch gekennzeichnet,**
**dass** das Messgerät eine Verarbeitungseinrichtung (19) beinhaltet, und
**dass** die Verarbeitungseinrichtung (19) das differentielle Signal verarbeitet und/oder in einem
Speicher (20) speichert.

3. Messgerät nach Anspruch 1 oder 2,
**dadurch gekennzeichnet,**
**dass** der Signaladdierer bzw. Signalsubtrahierer (30) und/oder die Triggereinrichtung (18) mittels eines FPGA, d.h. field programmable gate array,
oder eines ASIC, d.h. application specific gated array, realisiert sind.

4. Messgerät nach einem der Ansprüche 1 bis 3,
**dadurch gekennzeichnet,**
**dass** die Einrichtungen mit jeweils einem Signalanschluss und einem Masseanschluss (31, 32) einen Tastkopf umfassen (31, 32).

5. Messgerät nach einem der Ansprüche 1 bis 4,
**dadurch gekennzeichnet,**
**dass** das Messgerät über eine Anzeigeeinrichtung (21) verfügt, und dass die Anzeigeeinrichtung (21) Ergebnisse durchgeführter Messungen anzeigt.

6. Messgerät nach einem der Ansprüche 1 bis 5,
**dadurch gekennzeichnet,**
**dass** der Echtzeitabschnitt (36) eingehende Signale mit einer Abtastrate der Analog-Digital-Wandler (13, 14) verarbeitet.

7. Messverfahren zur Messung von differentiellen Signalen, wobei von zwei Einrichtungen mit jeweils einem Signalanschluss und einem Masseanschluss (31, 32) jeweils ein Teilsignal eines differentiellen Signals aufgenommen wird,
wobei zwei Analog-Digital-Wandler (13,14) jeweils ein Teilsignal in ein digitales Teilsignal wandeln,
wobei die digitalen Teilsignale zu einem digitalen differentiellen Signal addiert oder subtrahiert werden, **dadurch gekennzeichnet,**
**dass** die Triggerung des digitalen differentiellen Signals anhand des digitalen differentiellen Signals durchgeführt wird, wobei das differentielle Signal weiterverarbeitet und/oder gespeichert wird.

8. Messverfahren nach Anspruch 7,
**dadurch gekennzeichnet,**
**dass** die Addition bzw. Subtraktion und/oder die Triggerung von einem FPGA, d.h. field programmable gate array, oder einem ASIC, d.h. application specific gated array, durchgeführt
werden.

9. Messverfahren nach einem der Ansprüche 7 oder 8,
**dadurch gekennzeichnet,**
**dass** die Einrichtungen mit jeweils einem Signalanschluss und einem Masseanschluss (31, 32) jeweils genau ein Signal aufnehmen.

10. Messverfahren nach einem der Ansprüche 7 bis 9,
**dadurch gekennzeichnet,**
**dass** Ergebnisse durchgeführter Messungen von einer Anzeigeeinrichtung (21) angezeigt werden.

## Claims

1. Measuring device for measurement of differential signals with a real time section (36),
wherein the real time section (36) comprises two units each with a signal terminal and a ground terminal (31, 32), two analogue-to-digital converters (13, 14), a signal adder and/or signal subtractor (30) and a trigger unit (18),
wherein the units each with a signal terminal and a ground terminal (31, 32) each pick up a part signal of a differential signal,
wherein the analogue-to-digital converters (13, 14) each convert a part signal into a digital part signal, wherein the signal adder or signal subtractor (30) adds the digital part signals to a digital differential signal or subtracts them,
**characterised in that**
the trigger unit (18) carries out triggering of the digital differential signal with reference to the digital differential signal.

2. Measuring device according to claim 1,
**characterised in that**
the measuring device comprises a processing unit (19), and
**in that** the processing unit (19) processes the differential signal and/or stores it in a memory (20).

3. Measuring device according to claim 1 or 2,
**characterised in that**
the signal adder or signal subtractor (30) and/or the trigger unit (18) are embodied in the form of an FPGA, i.e. a field programmable gate array, or an ASIC, i.e. an application specific gated array.

4. Measuring device according to one of claims 1 to 3,
**characterised in that**
the units each with a signal terminal and a ground terminal (31, 32) comprise a sensing head (31, 32).

5. Measuring device according to one of claims 1 to 4,
**characterised in that**
the measuring device has a display unit (21), and **in that** the display unit (21) displays measurements which have been carried out.

6. Measuring device according to one of claims 1 to 5,
**characterised in that**
the real time section (36) processes incoming signals with a sampling rate of the analogue-to-digital converters (13, 14).

7. Measuring method for measurement of differential signals,
wherein in each case a part signal of a differential signal is picked up by two units each with a signal terminal and a ground terminal (31, 32),
wherein two analogue-to-digital converters (13, 14) each convert a part signal into a digital part signal, wherein the digital part signals are added to a digital differential signal or subtracted,
**characterised in that**
the triggering of the digital differential signal is carried out with reference to the digital differential signal, and the differential signal is processed further and/or stored.

8. Measuring method according to claim 7,
**characterised in that**
the addition or subtraction and/or the triggering are carried out by an FPGA, i.e. a field programmable gate array, or an ASIC, i.e. an application specific gated array.

9. Measuring method according to one of claims 7 or 8,
**characterised in that**
the units each with a signal terminal and a ground terminal (31, 32) each pick up just one signal.

10. Measuring method according to one of claims 7 to 9,
**characterised in that**
results of measurements which have been carried out are displayed by a display unit (21).

## Revendications

1. Appareil de mesure pour mesurer des signaux différentiels, comprenant une partie-temps réel (36), appareil de mesure
dans lequel la partie-temps réel (36) renferme deux dispositifs comprenant chacun un raccord de branchement de signal et un raccord de branchement de masse (31, 32), deux convertisseurs analogiques-numériques (13, 14), un additionneur de signaux et/ou un soustracteur de signaux (30) et un dispositif de déclenchement (18), dans lequel les dispositifs comprenant chacun un raccord de branchement de signal et un raccord de branchement de masse (31, 32) assurent respectivement l'acquisition d'un signal partiel d'un signal différentiel,
dans lequel les convertisseurs analogiques-numériques (13, 14) convertissent respectivement un signal partiel en un signal partiel numérique,
dans lequel l'additionneur de signaux ou respectivement soustracteur de signaux (30) additionne ou respectivement soustrait les signaux partiels numériques pour former un signal différentiel numérique,
**caractérisé**
**en ce que** le dispositif de déclenchement (18) effectue un déclenchement du signal différentiel numérique au regard du signal différentiel numérique.

2. Appareil de mesure selon la revendication 1,
**caractérisé**
**en ce que** l'appareil de mesure renferme un dispositif de traitement (19), et
**en ce que** le dispositif de traitement (19) traite le signal différentiel et/ou le mémorise dans une mémoire (20) .

3. Appareil de mesure selon la revendication 1 ou la revendication 2,
**caractérisé**
**en ce que** l'additionneur de signaux ou respectivement soustracteur de signaux (30) et/ou le dispositif de déclenchement (18) sont réalisés au moyen d'un FPGA, c'est-à-dire un "field programmable gate array" (réseau ou circuit logique programmable), ou d'un ASIC, c'est-à-dire un "application specific gated array" (circuit intégré propre à une application).

4. Appareil de mesure selon l'une des revendications 1 à 3,
**caractérisé**
**en ce que** les dispositifs comprenant chacun un raccord de branchement de signal et un raccord de branchement de masse (31, 32) comportent chacun une sonde (31, 32).

5. Appareil de mesure selon l'une des revendications 1 à 4,
**caractérisé**
**en ce que** l'appareil de mesure dispose d'un dispositif de visualisation (21) et en ce que le dispositif de visualisation (21) affiche des résultats de mesures ayant été effectuées.

6. Appareil de mesure selon l'une des revendications 1 à 5,
**caractérisé**
**en ce que** la partie-temps réel (36) traite les signaux entrants avec un taux d'échantillonnage des convertisseurs analogiques-numériques (13, 14).

7. Procédé de mesure pour mesurer des signaux différentiels,
d'après lequel deux dispositifs comprenant chacun un raccord de branchement de signal et un raccord de branchement de masse (31, 32) assurent respectivement l'acquisition d'un signal partiel d'un signal différentiel,
d'après lequel deux convertisseurs analogiques-numériques (13, 14) convertissent respectivement un signal partiel en un signal partiel numérique,
et d'après lequel les signaux partiels numériques sont additionnés ou soustraits en un signal différentiel numérique,
**caractérisé**
**en ce que** le déclenchement du signal différentiel numérique est effectué au regard du signal différentiel numérique, le signal différentiel continuant à être traité et/ou étant mémorisé.

8. Procédé de mesure selon la revendication 7,
**caractérisé**
**en ce que** l'addition ou respectivement la soustraction et/ou le déclenchement sont effectués par un FPGA, c'est-à-dire un "field programmable gate array" (réseau ou circuit logique programmable), ou par un ASIC, c'est-à-dire un "application specific gated array" (circuit intégré propre à une application).

9. Procédé de mesure selon l'une des revendications 7 ou 8,
**caractérisé**
**en ce que** les dispositifs comprenant chacun un raccord de branchement de signal et un raccord de branchement de masse (31, 32) assurent respectivement l'acquisition d'exactement un signal.

10. Procédé de mesure selon l'une des revendications 7 à 9,
**caractérisé**
**en ce que** des résultats de mesures ayant été effectuées sont affichés par un dispositif de visualisation (21).
